(19) Europäisches Patentamt / European Patent Office / Office européen des brevets

(11) **EP 4 701 006 A1**

(12) **EUROPÄISCHE PATENTANMELDUNG**

(43) Veröffentlichungstag:
   **25.02.2026 Patentblatt 2026/09**

(21) Anmeldenummer: **25191198.8**

(22) Anmeldetag: **23.07.2025**

(51) Internationale Patentklassifikation (IPC):
   **H01S 5/0683** (2006.01)   **H01S 5/06** (2006.01)
   **H01S 5/062** (2006.01)

(52) Gemeinsame Patentklassifikation (CPC):
   **H01S 5/0617; G01S 7/48; H01S 5/0683;**
   H01S 5/06216

(84) Benannte Vertragsstaaten:
   **AL AT BE BG CH CY CZ DE DK EE ES FI FR GB
   GR HR HU IE IS IT LI LT LU LV MC ME MK MT NL
   NO PL PT RO RS SE SI SK SM TR**
   Benannte Erstreckungsstaaten:
   **BA**
   Benannte Validierungsstaaten:
   **GE KH LA MA MD TN**

(30) Priorität: **07.08.2024 DE 102024207475**

(71) Anmelder: **Robert Bosch GmbH**
   **70442 Stuttgart (DE)**

(72) Erfinder:
   • **Copeto, David**
    **71638 Ludwigsburg (DE)**
   • **Noe, Stefan**
    **70563 Stuttgart (DE)**
   • **Hoffarth, Joern**
    **72764 Reutlingen (DE)**

(54) **VERFAHREN ZUM ANPASSEN EINES DIODENSTROMS EINES LASER-SYSTEMS**

(57) Die Erfindung betrifft ein Verfahren (100) zum Anpassen eines Diodenstroms eines Laser-Systems (1), umfassend die nachfolgenden Schritte:
- Bestimmen (101) einer Änderung eines Integralanteils einer Regelung des Laser-Systems (1) in einem unmodulierten Laserbetrieb,
- Anpassen (102) des Diodenstroms des Laser-Systems (1) in einem modulierten Laserbetrieb auf Basis der bestimmten Änderung des Integralanteils, wobei sich der modulierte Laserbetrieb von dem unmodulierten Laserbetrieb dadurch unterscheidet, dass in dem modulierten Laserbetrieb eine Intensitätsmodulation bei der Lichtemission durchgeführt wird. Ferner betrifft die Erfindung ein Computerprogramm, eine Vorrichtung sowie ein Speichermedium zu diesem Zweck.

## Fig. 1

**Beschreibung**

Die Erfindung betrifft ein Verfahren zum Anpassen eines Diodenstroms eines Laser-Systems. Ferner betrifft die Erfindung ein Computerprogramm, eine Vorrichtung sowie ein Speichermedium zu diesem Zweck.

Stand der Technik

Eine präzise Steuerung eines Diodenstroms in einem Laser-System ist von entscheidender Bedeutung für eine Vielzahl von Anwendungen, die auf die genaue Emission von Laserlicht angewiesen sind. In der Messtechnik, insbesondere bei Laser-Entfernungsmessgeräten, ist die exakte Regelung des Diodenstroms wesentlich, um die Stabilität und Präzision der Lichtquelle zu gewährleisten. Ein ungenau geregelter Diodenstrom kann zu Fluktuationen in der Laserleistung führen, was die Messgenauigkeit und Zuverlässigkeit erheblich beeinträchtigt. Zudem beeinflusst der Diodenstrom direkt die Modulationseigenschaften des Lasers, die für die Phasenverschiebungsmessung im Time-of-Flight-Verfahren (ToF) essentiell sind. Eine konstante und präzise Stromzufuhr gewährleistet nicht nur eine stabile Lichtintensität, sondern auch eine konsistente Wellenlänge und spektrale Reinheit des emittierten Lichts. Dies ist besonders wichtig in anspruchsvollen Umgebungen, in denen Temperatur- und Stromschwankungen auftreten können. Daher ist die Entwicklung fortschrittlicher Technologien zur präzisen Steuerung des Diodenstroms im Laser-System ein zentrales Anliegen, um die Leistungsfähigkeit und Genauigkeit von Laser-basierten Messgeräten und anderen optischen Systemen zu optimieren.

Offenbarung der Erfindung

Gegenstand der Erfindung ist ein Verfahren mit den Merkmalen des Anspruchs 1, ein Computerprogramm mit den Merkmalen des Anspruchs 8, eine Vorrichtung mit den Merkmalen des Anspruchs 9 sowie ein computerlesbares Speichermedium mit den Merkmalen des Anspruchs 10. Weitere Merkmale und Details der Erfindung ergeben sich aus den jeweiligen Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit dem erfindungsgemäßen Computerprogramm, der erfindungsgemäßen Vorrichtung sowie dem erfindungsgemäßen computerlesbaren Speichermedium, und jeweils umgekehrt, so dass bezüglich der Offenbarung der Erfindung stets auch eine wechselseitige Bezugnahme möglich ist.

Gegenstand der Erfindung ist insbesondere ein Verfahren zum Anpassen eines Diodenstroms eines Laser-Systems, umfassend die nachfolgenden Schritte, wobei die Schritte wiederholt und/oder nacheinander oder in einer bestimmten Reihenfolge durchgeführt werden können. Der Diodenstrom in dem Laser-System ist insbesondere der elektrische Strom, der durch die Halbleiter-Diode fließt, die für die Erzeugung von Laserlicht verwendet wird. Dieser Strom wird insbesondere durch Anlegen einer Spannung an die Diode erzeugt und fließt durch die aktive Schicht der Diode, die aus einem Halbleitermaterial wie Galliumarsenid besteht. Der Strom regt die Elektronen in der aktiven Schicht an und erzeugt so Photonen, die dann durch die Laserkavität verstärkt werden, um den Laserstrahl zu erzeugen. Der Diodenstrom ist insbesondere ein wichtiger Parameter für eine Steuerung einer Laserleistung und wird beispielsweise durch eine elektronische Schaltung gesteuert.

In einem ersten Schritt wird vorzugsweise eine Änderung eines Integralanteils einer Regelung des Laser-Systems in einem unmodulierten Laserbetrieb bestimmt.

Für einen reinen Integralregler (I-Regler) in einem Laser-System kann die Änderung des Integralanteils beispielsweise wie folgt bestimmt werden. Bei einem reinen I-Regler wird insbesondere nur der Integralanteil zur Regelung verwendet. Der I-Regler korrigiert den Regelungsfehler vorzugsweise, indem er eine Summe vergangener Fehler berücksichtigt. Der reine I-Regler kann durch die Gleichung $I(t) = K_i \int_0^t e(\tau)d\tau$ beschrieben werden, wobei $K_i$ die Verstärkung des I-Anteils und $e(\tau)$ der Regelungsfehler zum Zeitpunkt t ist.

Anschließend kann zum Ermitteln der Änderung des Integralanteils ein Modell des Laser-Systems und des reinen I-Reglers in einer Simulationsumgebung (z. B. MATLAB/Simulink) erstellt werden. Damit kann ein Verhalten des Laser-Systems mit dem I-Anteil simuliert werden und es können ferner relevante Daten wie der Regelungsfehler $e(\tau)$ und eine Ausgangsgröße des Systems ermittelt werden. Die aufgezeichneten Daten können anschließend analysiert werden. Alternativ zu der Simulation kann das Laser-System auch in einem laufenden Betrieb ausgelesen werden.

In einem weiteren Schritt wird vorzugsweise der Diodenstrom des Laser-Systems in einem modulierten Laserbetrieb auf Basis der bestimmten Änderung des Integralanteils angepasst. Dafür kann beispielsweise die bestimmte Änderung des Integralanteils in dem unmodulierten Laserbetrieb zu einem Integralanteil in dem modulierten Laserbetrieb hinzuaddiert oder in einer vergleichbaren Weise miteinander verrechnet werden.

Der modulierte Laserbetrieb unterscheidet sich dabei insbesondere dadurch von dem unmodulierten Laserbetrieb, dass in dem modulierten Laserbetrieb eine Intensitätsmodulation bei der Lichtemission, insbesondere der Lichtemission durch einen Laser, bzw. eine Laserdiode, des Laser-Systems, durchgeführt wird.

Durch das Verfahren gemäß der Erfindung kann es ermöglicht werden, dass eine Leistung und Stabilität des Lasers im modulierten Laserbetrieb optimiert und schneller eingestellt werden kann. Dadurch kann vorteilhaft schneller und mit einer höheren Präzision eine Messung auf Basis des emittierten Laserlichts durchgeführt werden, beispielsweise im Rahmen einer Entfernungsmessung.

Vorteilhaft ist es darüber hinaus, wenn im Rahmen der Erfindung das Anpassen spezifisch für eine in der Intensitätsmodulation verwendete Modulationsfrequenz durchgeführt wird, durch welche das durch eine Laserdiode emittierte Licht intensitätsmoduliert wird, wobei die Laserdiode durch den Diodenstrom betrieben wird. Es ist somit möglich, dass die Anpassung des Diodenstroms an die jeweilige Modulationsfrequenz erfolgt. Dadurch kann ein optimales Leistungs- und Stabilitätsniveau für jede Intensitätsmodulation erreicht werden.

Ein weiterer Vorteil kann im Rahmen der Erfindung erzielt werden, wenn für wenigstens zwei Modulationsfrequenz die Intensitätsmodulation durchgeführt wird und das Anpassen spezifisch für die jeweilige Modulationsfrequenz der wenigstens zwei Modulationsfrequenzen durchgeführt wird. Es ist somit möglich, dass für verschiedene Modulationsfrequenzen individuelle Anpassungen des Diodenstroms vorgenommen werden. Dies kann zu einer verbesserten Leistung und Genauigkeit des Laser-Systems, insbesondere Laser-Entfernungsmessgeräts, führen. Ferner kann eine geplante Störung bereits vorab kompensiert werden, sodass eine Ausregelung der Störung im Idealfall insbesondere erst gar nicht stattfinden muss.

Es kann von Vorteil sein, wenn im Rahmen der Erfindung das Bestimmen geräteindividuell für das Laser-System durchgeführt wird. Die spezifische Bestimmung des Integralanteils in Abhängigkeit vom individuellen Laser-System kann vorteilhaft eine feinere Anpassung des Diodenstroms und somit eine präzisere Steuerung der Laserleistung im modulierten Laserbetrieb ermöglichen.

Zudem ist im Rahmen der Erfindung denkbar, dass das Bestimmen wiederholt während eines Betriebs des Laser-Systems durchgeführt wird, um die Änderung des Integralanteils dynamisch zu bestimmen. Dies kann den Vorteil haben, dass eine Anpassung des Diodenstroms an veränderte oder sich ändernde Betriebsparameter des Laser-Systems, beispielsweise aber auch eine sich ändernde Temperatur oder ein sich ändernder Luftdruck einer Umgebung des Laser-Systems, möglich ist. Der modulierte Laserbetrieb kann so in Echtzeit oder zumindest fortlaufend optimiert werden.

In einer weiteren Möglichkeit kann vorgesehen sein, dass das Anpassen den folgenden Schritt umfasst:

- Ermitteln eines Offsets für einen Eingabewert eines Digital-Analog-Wandlers des Laser-Systems auf Basis der bestimmten Änderung des Integralanteils,
- Addieren des ermittelten Offsets zu einem aktuellen Eingabewert des Digital-Analog-Wandlers des Laser-Systems, um diesen als neuen Eingabewert für den Digital-Analog-Wandler zu verwenden.

Dadurch kann die Anpassung des Diodenstroms präzise und effizient erfolgen. Die Ermittlung des Offsets für den Digital-Analog-Wandler ermöglicht insbesondere eine feine Steuerung der Intensitätsmodulation und somit eine verbesserte Anpassung der Leistung und Stabilität des Lasers.

Ferner ist es denkbar, dass das Laser-System ein Laser-Entfernungsmessgerät ist. Dadurch wird erreicht, dass das Verfahren zur Anpassung des Diodenstroms in einem Laser-Entfernungsmessgerät angewendet werden kann. Die präzise Einstellung des Diodenstroms ermöglicht eine zuverlässige und genaue Messung der Entfernung durch die Phasenverschiebung des reflektierten Lichtsignals.

Ebenfalls Gegenstand der Erfindung ist ein Computerprogramm, insbesondere Computerprogrammprodukt, umfassend Befehle, die bei der Ausführung des Computerprogrammes durch einen Computer diesen veranlassen, das erfindungsgemäße Verfahren auszuführen. Damit bringt das erfindungsgemäße Computerprogramm die gleichen Vorteile mit sich, wie sie ausführlich mit Bezug auf ein erfindungsgemäßes Verfahren beschrieben worden sind.

Ebenfalls Gegenstand der Erfindung ist eine Vorrichtung zur Datenverarbeitung, die eingerichtet ist, das erfindungsgemäße Verfahren auszuführen. Als die Vorrichtung kann bspw. ein Computer vorgesehen sein, welcher das erfindungsgemäße Computerprogramm ausführt. Der Computer kann wenigstens einen Prozessor zur Ausführung des Computerprogramms aufweisen. Auch kann ein nicht-flüchtiger Datenspeicher vorgesehen sein, in welchem das Computerprogramm hinterlegt und von welchem das Computerprogramm durch den Prozessor zur Ausführung ausgelesen werden kann. Die Vorrichtung kann auch eine analoge diskrete elektronische Schaltung oder eine integrierte elektronische Schaltung sein, die entsprechend eingerichtet ist, das erfindungsgemäße Verfahren auszuführen.

Ebenfalls Gegenstand der Erfindung kann ein computerlesbares Speichermedium sein, welches das erfindungsgemäße Computerprogramm aufweist und/oder Befehle umfasst, die bei der Ausführung durch einen Computer diesen veranlassen, das erfindungsgemäße Verfahren auszuführen. Das Speichermedium ist bspw. als ein Datenspeicher wie eine Festplatte und/oder ein nicht-flüchtiger Speicher und/oder eine Speicherkarte ausgebildet. Das Speichermedium kann z. B. in den Computer integriert sein.

Darüber hinaus kann das erfindungsgemäße Verfahren auch als ein computerimplementiertes Verfahren ausgeführt sein. Alternativ oder zusätzlich kann zumindest einer der offenbarten Verfahrensschritte computer-implementiert sein und/oder automatisiert durchgeführt werden.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:

Fig. 1 eine schematische Visualisierung eines Verfahrens, einer Vorrichtung, eines Speichermediums sowie eines Computerprogramms gemäß Ausführungsbeispielen der Erfindung,

Fig. 2 eine schematische Darstellung eines Laser-Systems gemäß Ausführungsbeispielen der Erfindung.

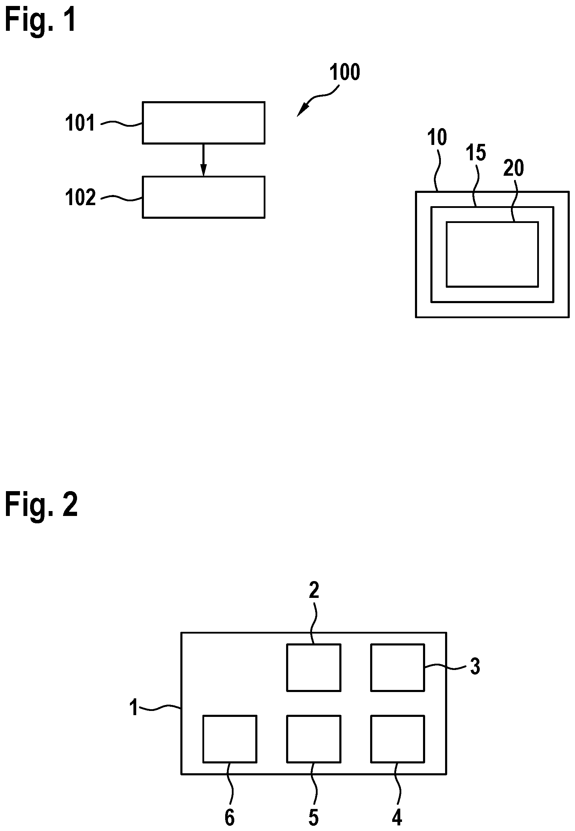

In Fig. 1 sind ein Verfahren 100, eine Vorrichtung 10, ein Speichermedium 15 sowie ein Computerprogramm 20 gemäß Ausführungsbeispielen der Erfindung schematisch dargestellt.

Fig. 1 zeigt insbesondere ein Ausführungsbeispiel für ein Verfahren 100 zum Anpassen eines Diodenstroms eines Laser-Systems 1. In einem ersten Schritt 101 wird eine Änderung eines Integralanteils einer Regelung des Laser-Systems 1 in einem unmodulierten Laserbetrieb bestimmt. In einem zweiten Schritt 102 wird der Diodenstrom des Laser-Systems 1 in einem modulierten Laserbetrieb auf Basis der bestimmten Änderung des Integralanteils angepasst. Der modulierte Laserbetrieb unterscheidet sich dabei insbesondere dadurch von dem unmodulierten Laserbetrieb, dass in dem modulierten Laserbetrieb eine Intensitätsmodulation bei der Lichtemission durchgeführt wird.

Das Verfahren der vorliegenden Erfindung betrifft ein Laser-System 1 und gemäß Ausführungsbeispielen insbesondere ein Laser-Entfernungsmessgerät, das die indirekte Time of Flight (iToF)-Messung verwendet. Für dieses Ausführungsbeispiel sei auf Fig. 2 verwiesen. Dieses Laser-Entfernungsmessgerät 1 arbeitet beispielsweise mit einer Messung einer Phasenverschiebung eines modulierten Lichtsignals, das vom Laser-Entfernungsmessgerät ausgesendet und von einem Zielobjekt reflektiert wird. Im Folgenden wird die Funktionsweise der indirekten Time of Flight (iToF)-Messung beschrieben. Zunächst kann eine Laserdiode 3 im Laser-Entfernungsmessgerät 1 intensitätsmoduliertes Licht, beispielsweise im infraroten oder sichtbaren Bereich, in Richtung eines Zielobjekts senden. Die Modulation erfolgt insbesondere mit einer sinusförmigen oder Rechteckwelle. Das intensitätsmodulierte Licht trifft anschließend auf das Zielobjekt und wird zurück zum Laser-Entfernungsmessgerät 1 reflektiert. Ein Detektor 4 im Messgerät kann nun das reflektierte Licht empfangen. Da das Licht eine gewisse Zeit benötigt, um die Strecke hin und zurück zu legen, kommt es zu einer Phasenverschiebung zwischen dem ausgesendeten und dem empfangenen Signal. Diese Phasenverschiebung zwischen dem ausgesendeten und dem empfangenen Signal kann anschließend gemessen werden. Diese Phasenverschiebung ist insbesondere proportional zur zurückgelegten Entfernung des Lichts. Die Entfernung kann anschließend aus der Phasenverschiebung unter Berücksichtigung der Wellenlänge der Modulation und der Lichtgeschwindigkeit berechnet werden. Hierbei kann ferner vorgesehen sein, dass eine Referenzphase mit einem zweiten Detektor mit einem konstanten Abstand bestimmt wird (nicht dargestellt), um die Phasenverschiebung auf Basis eines Vergleiches mit der Referenzphase zu bestimmen.

Das Laser-Entfernungsmessgerät 1 kann einen Messregler 2 aufweisen. Der Messregler 2 übernimmt insbesondere eine Steuerung des Lasers 3.

So kann der Messregler 2 eine Emission des Lasers 3 steuern, indem er ein Ein- und Ausschalten sowie eine Intensität und die Modulation eines Laserstrahls des Lasers 3 regelt. Dadurch kann sichergestellt werden, dass der Laserstrahl mit der richtigen Leistung und den richtigen Eigenschaften ausgesendet wird.

Ferner kann ein Laserstrahl des Laser-Systems 1 moduliert werden, beispielsweise in Form von gepulstem Licht und/oder einer kontinuierlichen Welle mit variabler Modulationsfrequenz. Nach dem Empfang zumindest eines Bruchteils des emittierten Laserlichts durch den Detektor 4 kann der Messregler 2 das empfangene Signal verarbeiten. Dies umfasst beispielsweise eine Verstärkung, Filterung und Umwandlung des empfangenen analogen Signals in ein digitales Signal zur weiteren Analyse, insbesondere durch einen Analog-Digital-Wandler 5. Ferner kann die Phasenverschiebung zwischen dem ausgesendeten und dem empfangenen Signal messen und gegebenenfalls mit der Referenzphase verglichen werden.

Der Messregler 2 kann ferner regelmäßig Kalibrierungen durchführen, um sicherzustellen, dass die Messungen präzise sind. Dafür kann er einen Zustand des Lasers 3 und des Detektors 4 überwachen, um sicherzustellen, dass diese ordnungsgemäß funktionieren.

Zudem kann das Laser-System 1, insbesondere das Laser-Entfernungsmessgerät, einen Analog-Digital-Wandler 5 aufweisen. Der Analog-Digital-Wandler 5 wandelt vorzugsweise analoge Signale, die vom Detektor 4 empfangen werden, in digitale Signale um. Diese Signale repräsentieren insbesondere eine Lichtintensität, die von der Laserdiode 3 ausgesendet wird. Die digitale Umwandlung kann es ermöglichen, die Phasenverschiebung zwischen dem ausgesendeten und dem empfangenen Signal zu analysieren. Die digitalen Signale, die vom Analog-Digital-Wandler 5 bereitgestellt werden, können weiter gefiltert, verstärkt und verarbeitet werden, um Rauschen zu reduzieren und die Signalqualität zu verbessern.

Ein Digital-Analog-Wandler 6 in dem Laser-System 1, bzw. Laser-Entfernungsmessgerät, hat insbesondere die Aufgabe, digitale Steuersignale in analoge Signale umzuwandeln. Diese analogen Signale können verwendet werden, um verschiedene Komponenten des Laser-Systems 1, insbesondere die Laserdiode 3, präzise zu steuern. Der Digital-Analog-Wandler 6 erzeugt vorzugsweise analoge Spannungen oder Ströme, die benötigt werden, um die Laserdiode 3 zu betreiben und zu modulieren. Diese Steuerung ist entscheidend für die Emission des Laserstrahls mit der gewünschten Intensität und Modulation. Durch eine Umwandlung digitaler Modulationsbefehle in analoge Signale kann der Digital-Analog-Wandler 6 die Modulation des Laserstrahls steuern. Dies kann gepulstes Licht oder eine kontinuierliche Welle mit variabler Modulationsfrequenz umfassen. Ferner kann der Digital-Analog-Wandler 6 digitale Rückmeldungen des Messreglers 2 in analoge Steuerungen umwandeln, um kontinuierlich die Leistung und Stabilität der Laserdiode 3 anzupassen.

Der Messregler 2 generiert vorzugsweise digitale Signale basierend auf Anforderungen des Messprozesses und Rückmeldungen von Sensoren und anderen Komponenten. Diese digitalen Signale werden insbesondere an den Digital-Analog-Wandler 6 gesendet. Der Digital-Analog-Wandler 6 wandelt die empfangenen digitalen Signale vorzugsweise in analoge Spannungen oder Ströme um. Diese analogen Signale können dann verwendet werden, um die Laserdiode 3 und andere analoge Komponenten zu steuern.

Während jedem Wechsel einer Modulationsfrequenz wird gemäß Ausführungsbeispielen vorzugsweise ein zur Effizienz der nächsten Modulationsfrequenz passender Offset geladen und damit der Diodenstrom schon vorab passend zur Effizienz verschoben. Die Offsets können bestimmt werden, indem eine Integralanteil-Änderung im unmodulierten Fall ausgelesen wird. Das kann entweder vorab im Labor ausgelesen und für alle Laser-Systeme 1 gleich eingestellt werden oder in der Fertigung geräteindividuell kalibriert werden oder dynamisch im Laser-System 1 ständig automatisch bestimmt und nachgezogen werden.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

**Patentansprüche**

1. Verfahren (100) zum Anpassen eines Diodenstroms eines Laser-Systems (1), umfassend die nachfolgenden Schritte:

    - Bestimmen (101) einer Änderung eines Integralanteils einer Regelung des Laser-Systems (1) in einem unmodulierten Laserbetrieb,
    - Anpassen (102) des Diodenstroms des Laser-Systems (1) in einem modulierten Laserbetrieb auf Basis der bestimmten Änderung des Integralanteils,

    wobei sich der modulierte Laserbetrieb von dem unmodulierten Laserbetrieb dadurch unterscheidet, dass in dem modulierten Laserbetrieb eine Intensitätsmodulation bei der Lichtemission durchgeführt wird.

2. Verfahren (100) nach Anspruch 1,
    **dadurch gekennzeichnet,**
    **dass** das Anpassen (102) spezifisch für eine in der Intensitätsmodulation verwendete Modulationsfrequenz durchgeführt wird, durch welche das durch eine Laserdiode (3) emittierte Licht intensitätsmoduliert wird, wobei die Laserdiode durch den Diodenstrom betrieben wird.

3. Verfahren (100) nach Anspruch 2,
    **dadurch gekennzeichnet,**
    **dass** für wenigstens zwei Modulationsfrequenz die Intensitätsmodulation durchgeführt wird und das Anpassen (102) spezifisch für die jeweilige Modulationsfrequenz der wenigstens zwei Modulationsfrequenzen durchgeführt wird.

4. Verfahren (100) nach einem der vorhergehenden Ansprüche,
    **dadurch gekennzeichnet,**
    **dass** das Bestimmen (101) geräteindividuell für das Laser-System (1) durchgeführt wird.

5. Verfahren (100) nach einem der vorhergehenden Ansprüche,
    **dadurch gekennzeichnet,**
    **dass** das Bestimmen (101) wiederholt während eines Betriebs des Laser-Systems (1) durchgeführt wird, um die Änderung des Integralanteils dynamisch zu bestimmen.

6. Verfahren (100) nach einem der vorhergehenden Ansprüche,
    **dadurch gekennzeichnet,**
    **dass** das Anpassen (102) den folgenden Schritt umfasst:

    - Ermitteln eines Offsets für einen Eingabewert eines Digital-Analog-Wandlers (6) des Laser-Systems (1) auf Basis der bestimmten Änderung des Integralanteils,
    - Addieren des ermittelten Offsets zu einem aktuellen Eingabewert des Digital-Analog-Wandlers (6) des Laser-Systems (1), um diesen als neuen Eingabewert für den Digital-Analog-Wandler (6) zu verwenden.

7. Verfahren (100) nach einem der vorhergehenden Ansprüche,
    **dadurch gekennzeichnet,**
    **dass** das Laser-System (1) ein Laser-Entfernungsmessgerät ist.

**8.** Computerprogramm (20), umfassend Befehle, die bei der Ausführung des Computerprogramms (20) durch einen Computer (10) diesen veranlassen, das Verfahren (100) nach einem der vorhergehenden Ansprüche auszuführen.

**9.** Vorrichtung (10) zur Datenverarbeitung, die eingerichtet ist, das Verfahren (100) nach einem der Ansprüche 1 bis 7 auszuführen.

**10.** Computerlesbares Speichermedium (15), umfassend Befehle, die bei der Ausführung durch einen Computer (10) diesen veranlassen, die Schritte des Verfahrens (100) nach einem der Ansprüche 1 bis 7 auszuführen.

**Fig. 1**

**Fig. 2**

Europäisches
Patentamt

European
Patent Office

Office européen
des brevets

# EUROPÄISCHER RECHERCHENBERICHT

Nummer der Anmeldung

EP 25 19 1198

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | JP S59 90242 A (NIPPON ELECTRIC CO) 24. Mai 1984 (1984-05-24) * Absätze [0001] - [0003]; Abbildungen 1,2 * | 1-6 | INV. H01S5/0683 H01S5/06 |
| X | ----- JP S62 169386 A (SEIKO EPSON CORP) 25. Juli 1987 (1987-07-25) * Absätze [0001] - [0003]; Abbildungen 1-6 * | 1-6 | ADD. H01S5/062 |
| X | ----- US 2010/220952 A1 (SMITH ROBERT W [US] ET AL) 2. September 2010 (2010-09-02) * Absätze [0024] - [0044]; Abbildungen 1,2 * | 1-10 | |
| X | ----- US 5 812 572 A (KING JEFFREY V [US] ET AL) 22. September 1998 (1998-09-22) * Spalte 4, Zeile 21 - Spalte 11, Zeile 57; Abbildungen 1-7 * ----- | 1-10 | |

RECHERCHIERTE SACHGEBIETE (IPC)

H01S

Der vorliegende Recherchenbericht wurde für alle Patentansprüche erstellt

EPO FORM 1503 03.82 (P04C03)

| Recherchenort | Abschlußdatum der Recherche | Prüfer |
|---|---|---|
| München | 18. Dezember 2025 | Laenen, Robert |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument
...........................................................................
& : Mitglied der gleichen Patentfamilie, übereinstimmendes
Dokument

**ANHANG ZUM EUROPÄISCHEN RECHERCHENBERICHT
ÜBER DIE EUROPÄISCHE PATENTANMELDUNG NR.**

EP 25 19 1198

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

18-12-2025

| Im Recherchenbericht angeführtes Patentdokument | Datum der Veröffentlichung | Mitglied(er) der Patentfamilie | Datum der Veröffentlichung |
|---|---|---|---|
| JP S5990242 A | 24-05-1984 | KEINE | |
| JP S62169386 A | 25-07-1987 | KEINE | |
| US 2010220952 A1 | 02-09-2010 | KEINE | |
| US 5812572 A | 22-09-1998 | AU 3508797 A | 21-01-1998 |
| | | US 5812572 A | 22-09-1998 |
| | | WO 9800893 A1 | 08-01-1998 |

Für nähere Einzelheiten zu diesem Anhang : siehe Amtsblatt des Europäischen Patentamts, Nr.12/82